# EUROPEAN PATENT SPECIFICATION

(11) **EP 2 796 579 B1**
(45) Date of publication and mention of the grant of the patent: **23.10.2019**
(21) Application number: 14160218.5
(22) Date of filing: 17.03.2014
(51) Int. Cl.: C22C 26/00, B22F 3/105, B22F 3/14, H01L 21/48, H01L 23/373

(54) **CU-DIAMOND BASED SOLID PHASE SINTERED BODY HAVING EXCELLENT HEAT RESISTANCE, HEAT SINK USING THE SAME, ELECTRONIC DEVICE USING THE HEAT SINK, AND METHOD FOR PRODUCING CU-DIAMOND BASED SOLID PHASE SINTERED BODY**
CU-DIAMANT-BASIERTE FESTPHASENSINTERKÖRPER MIT AUSGEZEICHNETER WÄRMEBESTÄNDIGKEIT, KÜHLKÖRPER DAMIT, ELEKTRONISCHE VORRICHTUNG MIT DEM KÜHLKÖRPER UND VERFAHREN ZUR HERSTELLUNG EINES CU-DIAMANT-BASIERTEN FESTPHASENSINTERKÖRPERS
CORPS FRITTÉ À PHASE SOLIDE À BASE DE CU-DIAMANT AYANT UNE EXCELLENTE RÉSISTANCE À LA CHALEUR, DISSIPATEUR DE CHALEUR UTILISANT CELUI-CI, DISPOSITIF ÉLECTRONIQUE UTILISANT LE DISSIPATEUR THERMIQUE, ET PROCÉDÉ DE PRODUCTION DE CORPS FRITTÉ À PHASE SOLIDE À BASE DE CU-DIAMANT

(30) Priority: 26.04.2013 JP 2013094357
(43) Date of publication of application: 29.10.2014
(73) Proprietor: Fuji Die Co., Ltd., Ohta-ku Tokyo 146-0092 (JP)
(72) Inventor: Ishii, Masayuki, Tokyo, 146-0092 (JP); Suzuki, Saki, Tokyo, 146-0092 (JP); Kitamura, Kozo, Tokyo, 146-0092 (JP); Tsuchiya, Kazuhiko, Tokyo, 146-0092 (JP); Saito, Minoru, Tokyo, 146-0092 (JP); Terada, Osamu, Tokyo, 146-0092 (JP); Hayashi, Koji, Saitama, 346-0014 (JP)
(74) Representative: Weickmann & Weickmann PartmbB

(56) References cited:
- CN-A- 101 615 600
- JP-A- H1 081 586
- CHU K ET AL: "Thermal conductivity of SPS consolidated Cu/diamond composites with Cr-coated diamond particles", JOURNAL OF ALLOYS AND COMPOUNDS, ELSEVIER SEQUOIA, LAUSANNE, CH, vol. 490, no. 1-2, 4 February 2010 (2010-02-04), pages 453-458, XP026859052, ISSN: 0925-8388 [retrieved on 2009-11-06]
- SCHUBERT ET AL: "Interfacial design of Cu-based composites prepared by powder metallurgy for heat sink applications", MATERIALS SCIENCE AND ENGINEERING A: STRUCTURAL MATERIALS:PROPERTIES, MICROSTRUCTURE & PROCESSING, LAUSANNE, CH, vol. 475, no. 1-2, 28 January 2008 (2008-01-28), pages 39-44, XP022435921, ISSN: 0921-5093, DOI: 10.1016/J.MSEA.2006.12.146
- SCHUBERT ET AL: "Interfacial characterization of Cu/diamond composites prepared by powder metallurgy for heat sink applications", SCRIPTA MATERIALIA, ELSEVIER, AMSTERDAM, NL, vol. 58, no. 4, 7 November 2007 (2007-11-07), pages 263-266, XP022362108, ISSN: 1359-6462, DOI: 10.1016/J.SCRIPTAMAT.2007.10.011

## Description

### BACKGROUND OF THE INVENTION

### FIELD OF THE INVENTION

The present invention relates to a heat sink and a material thereof, for a semiconductor laser submount, a power semiconductor (LDMOS=Lateral Double Diffused Metal-Oxide-Semiconductor Field-Effect Transistor) substrate, and a central processing unit (CPU), etc.

### DESCRIPTION OF THE RELATED ART

Since an amount of Joule heat or the like increases in the field of an automobile or an electric product with an increase in packaging density and higher power of an electronic component, a temperature increase is remarkable. The problem of the field is efficient heat dissipation. When high heat dissipation is particularly required, a heat sink having heat conductivity of 500 W/m·K or more is attached. And as such heat sink material, a Cu-diamond based composite material (Patent Literatures 1, 2, and 3) is used.

### [Prior Art Documents]

### [Patent Literature]

[Patent Literature 1] Japanese Patent Application Laid-Open No. 2005-184021
[Patent Literature 2] National Publication of International Patent Application No. 2006-519928
[Patent Literature 3] National Publication of International Patent Application No. 2007-535151
[Patent Literature 4] Japanese Patent Application Laid-Open No. 2010-155324
[Patent Literature 5] Chinese Patent Application CN 101615600 A

### [Non-Patent Literature]

[Non-Patent Literature 1] T.Schubert, B.Trindade, T.Weiβgarber and B.Kieback: "Interfacial design of Cu-based composites prepared by powder metallurgy for heat sink applications", Materials Science and Engineering A, 475, 2008, p.39-44
[Non-Patent Literature 2] Kiyoshi Mizuuchi, Kanryu Inoue, Yasuyuki Agari, Shinji Yamada, Masami Sugioka, Masao Itami, Masakazu Kawahara and Yukio Makino: "Consolidation and Thermal Conductivity of Diamond Particle Dispersed Copper Matrix Composites Produced by Spark Plasma Sintering (SPS)", Journal of the Japan Institute of Metals, 71, 2007, p.1066-1069, (in Japanese)
[Non-Patent Literature 3] T.Schubert, L.Ciupinski, W.Zielinski, A.Michalski, T.Weiβgarber and B.Kieback: "Interfacial characterization of Cu/diamond composites prepared by powder metallurgy for heat sink applications", Scripta Materialia, 58, 2008, p.263-266
[Non-Patent Literature 4] Tai-Whan Lim and Koji Hayashi: "Effects of Equilibrium Pressure of Gas Generated by Ruduction Reaction on Sintering Densification of MIM Fine Powders", Journal of the Japan Society of Powder and Powder Metallurgy, 40, 1993, p.373-378, (in Japanese)

### SUMMARY OF THE INVENTION

### Problems to be Solved by the Invention

As a conventional general method for producing a Cu-diamond based composite material, the following methods are used: a method for producing a Cu-diamond based composite material including the step of suction-infiltrating a Cu molten metal into gaps between diamond powders which are filled in a tube; a method for producing a Cu-diamond based composite material including the step of causing a Cu molten metal to infiltrate gaps between diamond powders; a method for producing a Cu-diamond based composite material including the step of pressure heating a Cu-diamond mixed powder with an ultrahigh pressure press; and a method for producing a Cu-diamond based composite material including the step of subjecting a Cu-diamond mixed powder to electric current pressure sintering.

The method using the Cu molten metal has a risk that the heat conductivity of the composite material becomes lower than an expectation value since a diamond particle is graphitized when the diamond particle is heated to a high temperature of about 1100 to 1300°C which is higher than a melting point of Cu. The method makes it difficult to stably provide a predetermined heat conductivity because of both fluctuation in a heating time of the diamond particle and composition nonuniformity of the molten metal. A Cu-diamond based composite material having high heat conductivity expected from the values of the heat conductivities of Cu and diamond is not obtained.

The heat conductivity lower than the expectation value is considered to be caused by gaps generated along the interface between Cu and the diamond particle by heating, that is by a low adhesion force between Cu and the diamond particle. It is described that the mechanism lies in a dimension change based on a difference between these thermal coefficient and the graphitization of the surface part of the diamond particle.

Herein, the related art covers the surface of the diamond particle with an Ag-Si eutectic alloy foil, and produces a composite material according to osmosis due to vacuum sintering and a helium gas pressure, to obtain a material having a relatively low thermal expansion coefficient, for the dimensional change due to the difference between those thermal expansion coefficients (Patent Literature 2).

Next, since the graphite caused by the deterioration of the surface of the diamond particle reacts with B, Cr and the like, to form a carbide, a method is proposed, which adds these elements to produce carbides of B, Cr and the like on the surface of the diamond particle, and to decrease the amount of graphite on the surface of the diamond particle, thereby improving the adhesion force between Cu and the diamond particle (Non-Patent Literatures 1 and 3).

Patent Literature 5 describes a packaging material comprising a reinforcement body from diamond grains, pure copper powder and a third component, selected from Cr, Mo, Si, Ti, or W, improving bonding of diamond and copper particles.

The method using the ultrahigh pressure press is likely to provide high heat conductivity owing to densification of 100%, and the performance is also relatively stable. However, the operation cost of the ultrahigh pressure press is high. Since the ultrahigh pressure press cannot form the powder into a part shape, a processing cost for making a part is also high. Therefore, the cost improvement is required.

A method using pulse electric current pressure sintering (commonly known as SPS) provides densification of about 97%, and cannot provide complete densification. However, since the method performs solid phase sintering in heating at about 900°C in a short time, the method provides little deterioration of the diamond particle, and provides heat conductivity higher than 500 W/m·K. The method provides a cost lower than those of the infiltrating method and the pressure heating method using the ultrahigh pressure press, and thus is an expected method. However, it is known that after a solid phase sintered body is formed into a heat sink by heating in a mounting brazing treatment to a semiconductor, heat conductivity is remarkably decreased by the temperature increase, or heat conductivity decreases with a temperature increase by generation of heat when a mounting semiconductor is used, to result in remarkable deterioration in heat dissipation. Therefore, such heat sink found no practical use.

Before the present inventors make researches, the remarkable deterioration in the heat dissipation is considered to be caused by the remained pores in the Cu-diamond based composite material due to incomplete densification in the solid phase sintering, and low interface strength between Cu and the diamond. As a countermeasure technique for the decrease in the heat conductivity during the brazing treatment or the use, the related art performing SPS sintering with a diamond powder plated with Cu as a raw material for the purpose of an improvement in the interface strength between the diamond particle and Cu matrix has been reported (Non-Patent Literature 2). However, the remarkable deterioration in the heat dissipation caused by the decrease in the heat conductivity cannot be prevented in fact.

That is, since the conventional techniques pay attention only to the adhesion between Cu and the diamond particle, the treatment cannot improve the heat resistance.

### Means for Solving the Problems

First, the present inventors researched a method for improving heat conductivity resistance by addition of Cr to a Cu-diamond based composite material by using a pulse electric current sintering method (hereinafter, described as "SPS") which was a kind of a hot press and was considered to be practical.

That is, Cr was added at the maximum amount of 7 vol% to a Cu-50 vol% diamond such that Cu was substituted by Cr. The heat conductivities of a solid phase sintered body obtained by solid phase sintering by means of the SPS and a solid phase sintered body heat-treated at 300°C to 900°C in a vacuum or in a hydrogen gas of atmospheric pressure for 10 min to 30 min were measured. 300°C was assumed to be a temperature to which the solid phase sintered body was exposed when the solid phase sintered body was mounted as a heat sink on a semiconductor substrate. 900°C was assumed to be a temperature to which the solid phase sintered body was exposed in brazing when the solid phase sintered body was mounted on a semiconductor substrate or the like.

As a result, in the researches of the present inventors, high heat conductivity of 500 W/m·K or more was obtained even in Cr free specimens by the solid phase sintering with the SPS at 900°C for 1 min.

It has been found that a Cu-diamond solid phase sintered body having an aimed high heat conductivity can be obtained under an appropriate sintering condition since the high heat conductivity of 500 W/m·K or more is obtained even by no addition of Cr.

As the amount of Cr was further increased, the heat conductivity was gradually decreased. However, even when 6 vol% or less of Cr was added, the heat conductivity of 500 W/m·K or more was kept.

The heat conductivity gradually decreased according to the mixing rule as the amount of Cr is increased, probably because the heat conductivity of Cr is low, compared with that of Cu.

As described above, "add the carbide formation elements, i.e., B and Cr to produce their carbides and the like on the surface of the diamond particle, and to decrease the amount of graphite on the surface of the diamond particle, thereby improving the adhesion force between Cu and the diamond particle" which is clamed in Non-Patent Literature 1 is considered to be not necessarily important. This is the first finding.

Next, the heat conductivity of the solid phase sintered body heat-treated at 900°C for 10 min to 30 min under an atmospheric pressure in a hydrogen atmosphere is shown.

First, in the case of Cr free and 1 vol% Cr addition, the heat conductivity after the heat treatment at 900°C for 10 min in the hydrogen gas of atmospheric pressure was less than 500 W/m·K. Therefore, the deterioration in the performance caused by the heat treatment to be widely alleged could be confirmed.

When 2 vol% Cr to 3 vol% Cr-containing composite materials were heat-treated for 10 min at 900°C in the same atmosphere, the heat conductivity was not deteriorated. However, when the composite materials were heat-treated for 30 min at 900°C, the heat conductivities were deteriorated.

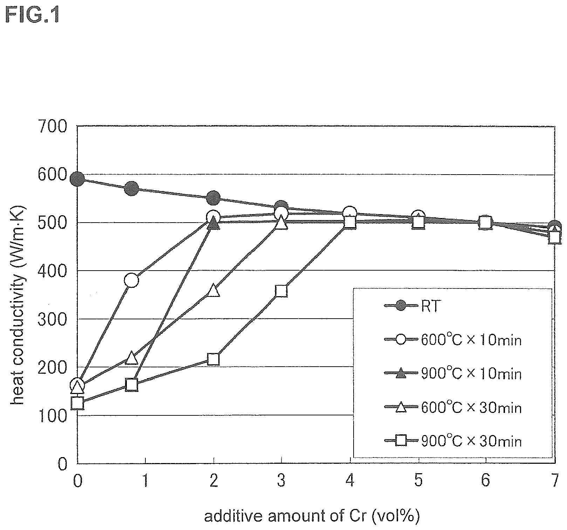

When 4 vol% Cr to 6 vol% Cr-containing composite materials were heat-treated for 10 min at 900°C, their heat conductivities were not deteriorated. Furthermore, when these composite material was heat-treated for 30 min at 900°C, ther heat conductivities were not deteriorated. The above results are shown in FIG. 1. This is a second finding.

Before the present inventors make researches, the decrease in the heat conductivity caused by the heat treatment and the cause thereof are not known in Patent Literatures 1 to 3 and Non-Patent Literature 1.

Next, the present inventors investigated whether gaps were produced along the interface between Cu and the diamond particle. As a result, it has been found that the shape of a Cu particle didn't change by the heat treatment and gaps were observed along the contact surface with the diamond particle in the Cr free solid phase sintered body. On the other hand, the gaps did not exist along a part of contact surface in the Cr-containing sintered body.

In the related technical documents in which liquid phase sintering is performed, the gaps are decreased by the addition of Cr since Cr₃C₂ is produced (Non-Patent Literatures 1 and 3). An element analysis for detail investigation was performed at low to high magnification with light-element-analyzing EPMA attached to a scanning electron microscope. However, the existence of Cr₃C₂ was not confirmed. Non-existence of Cr₃C₂ is considered to be caused by solid phase sintering in a short time. This is the third finding.

Meanwhile, one of the present inventors discloses that the cause why the maximum relative density of a sintered body containing an MIM fine powder such as Cu or Fe fine powder does not exceed 95 to 98% is due to the fact that "an equilibrium pressure in an isolated pore, of H₂O or a CO gas generated in a reduction reaction of an oxide with H₂ gas as a sintering atmosphere or C as impurities in the powder is higher than the surface stress (shrinkage driving force) of the isolated pore" (Non-Patent Literature 4).

Then, the present inventors paid attention to oxygen always contained in a Cu powder as the raw material, and made the following assumption.

First, if the Cu powder is heated in a hydrogen atmosphere (H₂), a small amount of oxygen contained in Cu reacts with an H₂ gas or C on a diamond surface to form H₂O, CO or CO₂ gas (hereinafter, described as COₓ), which forms pores along the interface between Cu and the diamond particle. Then, heat resistance of the interfacial contact increases, which causes a decrease in heat conductivity (i.e., thermal conductivity).

However, an absolute value of standard free energy of formation (ΔG⁰_{f}) of an oxide of Cr, i.e., CrOₓ, is greater than that of H₂O or COₓ. That is, CrOₓ is thermodynamically more stable than H₂O or COₓ. Thereby, when Cr is added to Cu, the small amount of oxygen contained in Cu substantially preferentially reacts with Cr, to form CrOₓ. Alternatively, even if the small amount of oxygen reacts with H which is solved in Cu from the heating atmosphere, H₂, or with diamond-like carbon in the diamond powder, or the like, to form an H₂O gas or a COₓ gas for a period of time at the beginning of heating, these change to H or C by the reaction of xH₂O + Cr = 2xH + CrOₓ or COₓ + Cr = C + CrOₓ with time. Thereby, the H₂O gas or the COₓ gas is not substantially generated in an equilibrium state. As a result, the gas layers are not generated along the interface between Cu and the diamond particle, and Cu and the diamond particle can adhere tightly to each other during sintering. That is, Cr acts as an oxygen getter.

Next, when Cr containing composite is heat-treated, CrOₓ having standard free energy of formation smaller than that of the H₂O gas or the COₓ gas is generated, and the H₂O gas or the CO gas is not generated. As a result, the H₂O gas or COₓ gas layer is not generated along the interface between Cu and the diamond particle.

As a result, Cr is theoretically considered to prevent the decrease in the adhesion of the interface between the Cu and diamond.

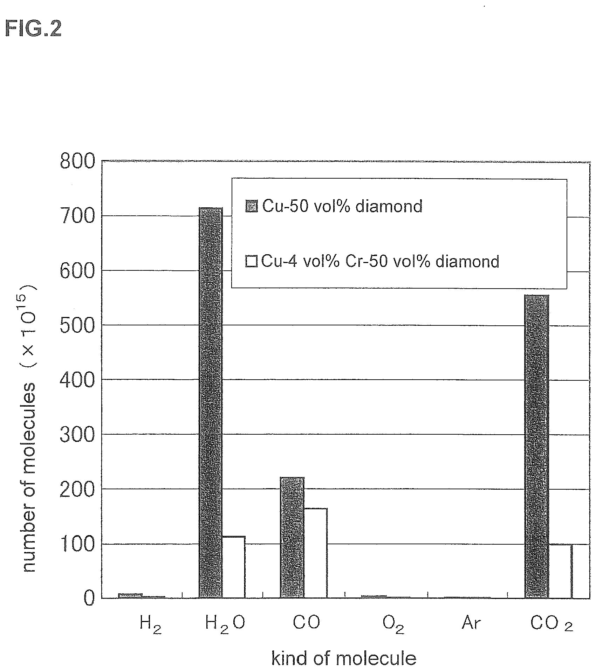

In order to confirm this consideration , it was investigated with a mass spectrometer whether the H₂O gas or the COₓ gas was generated when Cr free and 4 vol% Cr-containing Cu-diamond based solid phase sintered bodies were heated for 10 min at 900°C in a hydrogen atmosphere and then heated in a vacuum at 900°C. As a result, the gas amount generated from the 4 vol% Cr-containing Cu-diamond based solid phase sintered body was confirmed to be extremely less than that generated from the Cr free Cu-diamond based solid phase sintered body. These results are shown in FIG. 2.

From FIG. 2, it is found that the numbers of molecules of H₂O, CO, and CO₂ generated from the Cr-containing solid phase sintered body are extremely less. This shows that the present inventors' consideration is right.

That is, the addition effect of Cr on the heat conductivity is that the added Cr prevents the generation of H₂O gas or the COₓ gas. Thereby, (1) Since the H₂O gas or the COₓ gas is not generated along the interface between Cu and the diamond particle during sintering, Cu and the diamond particle can adhere tightly to each other during sintering, and (2) Since the added Cr changes to CrOₓ during the heat treatment by the reaction with the oxgen in Cu, and thereby the H₂O gas or the CO gas is not generated, the decrease in the adhesion of the interface between the Cu and diamond is prevented as a result. The present inventors discovered that the addition effect of Cr provides these two points. This is a fourth finding.

So, the same effect should be obtained by addition of an element besides Cr, which is likely to generate a stable oxide, and also is less likely to be solid-solved in Cu, for example, B and Zr.

However, B powder in the market is expensive. There are inexpensive Zr powders. However, such inexpensive Zr powders contain a large amount of ZrOₓ in the particle surface from the beginning. Thereby, even if the Zr powder is added to the Cu-diamond based composite material, new ZrOₓ is hardly generated. Accordingly, an effect preventing the generation of H₂O gas or the COₓ gas is hardly obtained by such Zr powder. Zr powders not containing a large amount of ZrOₓ are expensive. Moreover, Zr generates intermetallic compounds with Cu. Therefore, ZrOₓ may be less likely to be newly generated during sintering and heat treatment.

Cr powder is in the market as an element which is inexpensive and has relatively of high purity. Herein, if a Cr powder having less oxygen is used in a special process, a smaller additive amount of Cr powder can be attained. However, the special process has the drawback of expensive price. Therefore, a commercially available inexpensive Cr powder may be usually used (Non-Patent Literature 4). This is a fifth finding.

Next, the Raman shift of a commercially available diamond particle was investigated with a scanning type laser Raman microscope RAMAN-11 manufactured by Nanophoton Corporation.

The present inventors found that a peak (a peak at 1330 cm⁻¹ of Raman shift) of a diamond and a peak (a peak at 1450 cm⁻¹ of Raman shift) of diamond-like carbon (DLC) are observed in a diamond particle for a resin bond grinding stone, and the diamond particle includes a complex of the diamond and the DLC. The present inventors disclosed the related technology such as a grinding stone and a grinding method using such diamond particle (Patent Literature 4). That is, the present inventors disclose that an industrial diamond particle is not necessarily a single diamond phase.

Since the diamond particle having crystallinity higher than that of the diamond particle for the resin bond grinding stone was used in the present invention, the Raman shift of the diamond particle having high crystallinity was newly investigated in the same way as described above.

That is, the diamond powder was analyzed with the scanning type laser Raman microscope RAMAN-11 manufactured by Nanophoton Corporation. When a peak at 1330 cm⁻¹ of a diamond component was displayed as red and a peak at 1450 cm⁻¹ of a diamond-like carbon (DLC) component was displayed as green, the diamond component was divided into red, black red, red yellow, yellow, and green, as a result.

The red yellow and the yellow are those in which the red of the diamond and the green of the DLC are mixed, that is, a mixture of the diamond and the DLC. The black red is a diamond having weak Raman scattering for some reasons.

It was found that diamond particles hardly having the DLC component, that is, red and black red diamond particles are required in order to provide a Cu-50 vol% diamond solid phase sintered body having excellent heat resistance. Conversely, the DLC is required not to be contained. This is because the DLC is easily changed to the other carbon by heating and the added Cr is exhausted in the reaction of xC + Cr = CrCₓ, and the surface of the Cr particle is covered with CrCₓ to lose the generation inhibiting effect of H₂O and COₓ gas in the reactions of xH₂O + Cr = 2xH + CrOₓ and COₓ + Cr = C + CrOₓ.

Furthermore, it was also found that the proportion of the red diamond particle in the red and black red diamond particles must be 20 vol% or more. This is a sixth finding.

Next, when the proportion of the diamond is less than 30 vol%, heat conductivity is insufficient. When the proportion is more than 80 vol%, densification in sintering is extremely difficult. Therefore, the proportion is preferably 30 vol% or more and 80 vol% or less.

Furthermore, when the particle size of the diamond is less than 50 µm, the area of the interface (where heat conductivity is low) between the diamond and C increases, which results in insufficient heat conductivity of the composite material. When the particle size of the diamond is more than 500 µm, densification in sintering is extremely difficult. Therefore, the particle size is preferably 50 µm or more and 500 µm or less.

In the case of a large amount of diamond, for example, a Cu-80 vol% diamond composition, sintering is extremely difficult. However, the combination of diamond powders having different particle sizes such as diamond powders having particle sizes of 50 µm and 200 µm enables densification.

Herein, a sieving test using standard sieves or a laser diffraction type apparatus for measuring particle size distribution may be used to measure the particle size of the diamond.

In the method, the diamond powders are mixed with a usual method, and cold-pressed to form a compact. Then, the sintered body is produced with pressurizing solid phase sintering of a usual hot press, electric current pressure sintering apparatus or SPS. The pressurizing method may be a pressurizing method using a mold. This includes the hot press, the electric current pressure sintering apparatus, or the SPS, for example, but is not limited thereto.

When the pressing pressure in the usual hot press or the SPS is less than 20 MPa, densification in sintering is extremely difficult. When the pressing pressure is more than 50 MPa, a press mold may be broken. Therefore, the pressing pressure is preferably 20 MPa or more and 50 MPa or less. As long as a mold which can endure a higher pressure is used, the pressing pressure may be a higher pressure.

A sintering atmosphere is a vacuum or a reducing atmosphere such as Ar, to prevent the Cu and diamond from being oxidized.

When a sintering temperature is high and a large amount of liquid phase is produced, Cu exudes, which results in a non-constant component, and Cr changes to a carbide, which decreases heat conductivity. Thereby, Cr cannot be added at 2 vol% or more. Therefore, the sintering temperature in the usual hot press or the SPS is set to 1070°C or less.

When the sintering temperature is less than 800°C, densification in sintering is extremely difficult. The sintering temperature is preferably 800°C or more and 1070°C or less.

As described above, there was achieved the invention of the Cu-diamond based solid phase sintered body having excellent heat conductivity at room temperature and extremely little deterioration of the heat conductivity even if the Cu-diamond based solid phase sintered body was heated.

### [Advantageous Effects of the Invention]

The Cu-diamond based solid phase sintered body to which Cr is added according to the present invention can be inexpensively produced, and has excellent heat conductivity and heat resistance.

### BRIEF DESCRIPTION OF THE DRAWINGS

FIG. 1 shows the effects of Cr addition and a heating treatment condition on heat conductivity of a Cu-50 vol% diamond-based solid phase sintered body in a hydrogen atmosphere.
FIG. 2 shows the mass analysis results of gases which was generated when a Cu-50 vol% diamond solid phase sintered body or a Cu-4 vol% Cr-50 vol% diamond solid phase sintered body was heated to 900°C in a vacuum.

### DETAILED DESCRIPTION OF THE PREFERRED EMBODIMENTS

### [Example 1]

A Cu powder having a particle size of 5 µm and having an oxygen content of 0.2% by mass, five types of diamond powder of Table 1 having a particle size having of 200 µm, and a Cr powder having a particle size of 8.8 µm and having an oxygen content of 0.8% by mass were prepared as raw materials. Herein, the particle sizes of the Cu powder and the Cr powder are median values, d₅₀, measured with a laser diffraction type apparatus for measuring particle size distribution. The particle size of a diamond was determined with sieving.

The diamond powder was analyzed with a scanning type laser Raman microscope RAMAN-11 manufactured by Nanophoton Corporation. A peak at 1330 cm⁻¹ of a diamond component having high crystallinity was displayed as red and a peak at 1450 cm⁻¹ of a diamond- like carbon (DLC) component was displayed as green. The results divided into red, black red, red yellow, yellow, and green were subjected to image processing to obtain area rates, as described above. The area rates were defined to be equal to vol%, and Table 1 was obtained.

**[Table 1]**

| color display with Raman analysis | | type names and compositions of diamond powders (vol%) | | | | |
|---|---|---|---|---|---|---|
| | | D1 | D2 | D3 | D4 | D5 |
| red | diamond 1 | 3 | 24 | 21 | 31 | 36 |
| black red | diamond 2 | 58 | 45 | 79 | 69 | 64 |
| red yellow | mixture of diamond and DLC | 0 | 14 | 0 | 0 | 0 |
| yellow | intermediate of diamond and DLC | 27 | 15 | 0 | 0 | 0 |
| green | DLC | 12 | 2 | 0 | 0 | 0 |
| total | | 100 | 100 | 100 | 100 | 100 |

Next, a basic composition was designed to be a Cu-30 to 80 vol% diamond (Cr free). A composition to which Cr was added at a maximum of 7 vol% was also produced. These were produced with a discharge plasma sintering apparatus DR.SINTER (registered trademark) SPS-625 manufactured by Fuji Electronic Industrial Co., Ltd. The atmosphere in the apparatus was designed to be a vacuum of 10 Pa or less. The temperature increase rate was designed to be 200°C/min in the range from room temperature to 800°C. The temperature increase rate was designed to be 50°C/min in the range from 800°C to a sintering temperature. After the temperature reached the sintering temperature, the temperature was held for 1 min while electric current pressurizing was performed at 50 MPa. The body was then cooled to 400°C in 1 min, then furnace cooled, and taken out.

The sintering temperature was designed to be a temperature at which molten Cu was not excluded, e.g., 900°C to 940°C depending on the compositions. All the Cu-diamond based solid phase sintered bodies had a relative density of 95% or more.

The heat conductivities of the obtained Cu-diamond based solid phase sintered bodies at room temperature were measured as sintered state and after the sintered bodies were heat-treated for 30 min at 900°C in a hydrogen atmosphere (a dew point was about -50°C) of an atmospheric pressure. The results obtained were shown in Table 2.

**[Table 2]**

| | sample number | composition | additive amount of Cr | relative density | heat conductivity | evaluation of heat resistance | | | |
|---|---|---|---|---|---|---|---|---|---|
| | | | | | | heat conductivity (W/m·K) after being heated at each temperature for 10 min | | heat conductivity (W/m·K) after being heated at each temperature for 30 min | |
| | | (vol%) | (vol%) | (%) | (W/m·K) | | | | |
| | | | | | | 600°C | 900°C | 600°C | 900°C |
| comparative examples | 1 | Cu-20%D3 | 0 | 99 | 450 | 50 | 40 | 50 | 40 |
| | 2 | Cu-30%D3 | 0 | 99 | 500 | 70 | 60 | 70 | 60 |
| | 3 | Cu-40%D3 | 0 | 98 | 510 | 123 | 80 | 120 | 80 |
| | 4 | Cu-50%D3 | 0 | 97 | 525 | 163 | 126 | 160 | 126 |
| | 5 | Cu-60%D3 | 0 | 96 | 550 | 130 | 90 | 110 | 80 |
| | 6 | Cu-70%D3 | 0 | 95 | 520 | 100 | 70 | 90 | 60 |
| | 7 | Cu-80%D3 | 0 | 94 | 450 | 80 | 60 | 70 | 50 |
| | 4 | Cu-50%D3 | 0 | 97 | 590 | 163 | 126 | 160 | 126 |
| | 8 | Cu-50%D3 | 0.8 | 97 | 570 | 380 | 164 | 220 | 164 |
| present invention | 9 | Cu-50%D3 | 2 | 97 | 550 | 510 | 500 | 360 | 216 |
| | 10 | Cu-50%D3 | 3 | 97 | 530 | 518 | 502 | 500 | 357 |
| | 11 | Cu-50%D3 | 4 | 97 | 518 | 510 | 505 | 500 | 500 |
| | 12 | Cu-50%D3 | 5 | 97 | 510 | 500 | 500 | 500 | 500 |
| | 13 | Cu-50%D3 | 6 | 97 | 500 | 500 | 500 | 500 | 500 |
| comparative examples | 14 | Cu-50%D3 | 7 | 97 | 490 | 480 | 480 | 470 | 470 |
| | 5 | Cu-60%D3 | 0 | 96 | 550 | 130 | 90 | 110 | 80 |
| | 15 | Cu-60%D3 | 0.8 | 96 | 540 | 350 | 150 | 200 | 140 |
| present invention | 16 | Cu-60%D3 | 2 | 96 | 530 | 518 | 505 | 350 | 210 |
| | 17 | Cu-60%D3 | 3 | 96 | 520 | 510 | 500 | 490 | 340 |
| | 18 | Cu-60%D3 | 4 | 96 | 515 | 515 | 510 | 505 | 510 |
| | 19 | Cu-60%D3 | 5 | 96 | 510 | 510 | 502 | 500 | 500 |
| | 20 | Cu-60%D3 | 6 | 96 | 505 | 500 | 500 | 500 | 500 |
| comparative examples | 21 | Cu-60%D3 | 7 | 96 | 475 | 475 | 475 | 475 | 475 |
| | 6 | Cu-70%D3 | 0 | 95 | 520 | 100 | 70 | 90 | 60 |
| | 22 | Cu-70%D3 | 0.8 | 95 | 515 | 370 | 150 | 200 | 150 |
| present invention | 23 | Cu-70%D3 | 2 | 95 | 510 | 505 | 503 | 350 | 200 |
| | 24 | Cu-70%D3 | 3 | 95 | 505 | 504 | 500 | 490 | 340 |
| | 25 | Cu-70%D3 | 4 | 95 | 505 | 503 | 503 | 503 | 503 |
| | 26 | Cu-70%D3 | 5 | 95 | 503 | 502 | 500 | 500 | 500 |
| | 27 | Cu-70%D3 | 6 | 95 | 500 | 500 | 500 | 500 | 500 |
| comparative examples | 28 | Cu-70%D3 | 7 | 95 | 470 | 470 | 470 | 470 | 470 |

### [Example 2]

Cu-diamond based solid phase sintered bodies were produced in the same manner as in Example 1 except that the diamond powder D3 of Example 1 was replaced by D1, D2, D4, and D5. The heat conductivities of the Cu-diamond based solid phase sintered bodies at room temperature were measured on as-sintered body and the body heat-treated at 900°C for 30 min in a hydrogen atmosphere of an atmospheric pressure after sintering. The results obtained were shown in Table 3. The use of diamond particles containing many diamond components having higher crystallinity was found to provide higher heat conductivity at room temperature on as-sintered body and the heat-treated body.

**[Table 3]**

| | sample number | composition | additive amount of Cr | relative density | heat conductivity | evaluation of heat resistance | | | |
|---|---|---|---|---|---|---|---|---|---|
| | | | | | | heat conductivity (W/m·K) after being heated at each temperature for 10 min | | heat conductivity (W/m·K) after being heated at each temperature for 30 min | |
| | | (vol%) | (vol%) | (%) | (W/m·K) | | | | |
| | | | | | | 600°C | 900°C | 600°C | 900°C |
| comparative examples | 29 | Cu-50%D1 | 5 | 97 | 350 | 350 | 350 | 350 | 350 |
| | 30 | Cu-50%D2 | 5 | 97 | 550 | 450 | 450 | 450 | 450 |
| present invention | 9 | Cu-50%D3 | 2 | 97 | 550 | 510 | 500 | 360 | 216 |
| | 31 | Cu-50%D4 | 2 | 97 | 550 | 550 | 530 | 510 | 500 |
| | 32 | Cu-50%D4 | 5 | 97 | 550 | 550 | 550 | 550 | 550 |
| | 33 | Cu-50%D5 | 2 | 97 | 560 | 560 | 540 | 520 | 510 |
| | 34 | Cu-50%D5 | 5 | 97 | 560 | 560 | 560 | 560 | 560 |

### [Example 3]

Cu-30 vol% diamond based solid phase sintered bodies were produced in the same manner as in Example 1. The heat conductivities of the sintered bodies were measured at room temperature. The heat conductivities of the sintered bodies heat-treated at 900°C for 30 min in a hydrogen atmosphere of an atmospheric pressure were measured. The results obtained were in Table 4. This showed that the heat resistance at 600°C was obtained by the addition of 2 vol% of Cr in the Cu-30 vol% diamond-based solid phase sintered bodies.

**[Table 4]**

| | sample number | composition | additive amount of Cr | relative density | heat conductivity | evaluation of heat resistance | | | |
|---|---|---|---|---|---|---|---|---|---|
| | | (vol%) | (vol%) | (%) | (W/m·K) | heat conductivity (W/m·K) after being heated at each temperature for 10 min | | heat conductivity (W/m·K) after being heated at each temperature for 30 min | |
| | | | | | | 600°C | 900°C | 600°C | 1900°C |
| comparative examples | 35 | Cu-30%D1 | 0 | 99 | 450 | 60 | 50 | 40 | 30 |
| | 36 | Cu-30%D2 | 0 | 99 | 470 | 70 | 60 | 55 | 50 |
| present invention | 37 | Cu-30%D3 | 2 | 99 | 500 | 500 | 360 | 210 | 100 |
| | 38 | Cu-30%D3 | 6 | 99 | 500 | 500 | 500 | 500 | 500 |

### [Example 4]

Cu-80 vol% diamond-based solid phase sintered bodies containing D5 type diamonds of Table 1 having particle sizes of 50 µm and 200 µm were produced in the same manner as that in Example 1 except that the sintering temperature was held for 10 min under electric current pressurizing at 50 MPa when the temperature of the sintered bodies reached a sintering temperature. The heat conductivities of the body heat-treated at 900°C for 30 min in a hydrogen atmosphere of an atmospheric pressure were measured at room temperature. The results of Table 5 were obtained. This showed that the heat resistance at 600°C was obtained by the addition of 2 vol% of Cr for the Cu-80 vol% diamond-based solid phase sintered body.

**[Table 5]**

| | sample number | composition | additive amount of Cr | relative density | heat conductivity | evaluation of heat resistance | | | |
|---|---|---|---|---|---|---|---|---|---|
| | | (vol%) | (vol%) | (%) | (W/m·K) | heat conductivity (W/m·K) after being heated at each temperature for 10 min | | heat conductivity (W/m·K) after being heated at each temperature for 30 min | |
| | | | | | | 600°C | 900°C | 600°C | 900°C |
| comparative examples | 39 | Cu-80%D5 | 0 | 95 | 510 | 50 | 30 | 30 | 20 |
| | 40 | Cu-80%D5 | 1 | 95 | 510 | 100 | 50 | 40 | 30 |
| present invention | 41 | Cu-80%D5 | 2 | 95 | 508 | 500 | 330 | 150 | 90 |
| | 42 | Cu-80%D5 | 5 | 95 | 504 | 500 | 500 | 490 | 470 |

### [Industrial Applicability]

The heat sink including the material produced by the present invention and the electronic device including the heat sink have an excellent heat characteristic and economic efficiency. Therefore, the heat sink and the electronic device can extensively spread and be used in the electric instrument business field and the IT business field derived from them, thereby contributing to the high performance and low cost of the product in the same business fields.

## Claims

1. A Cu-diamond based solid phase sintered body comprising:
30 vol% or more and 80 vol% or less of a diamond; and
2 vol% or more and 6 vol% or less of Cr; with
the balance of the sintered body being Cu and inevitable impurities,
wherein the used raw material powder is an industrial synthesized diamond powder not comprising a red yellow, yellow, or green portion of a diamond powder, provided that the diamond powder is analyzed with a laser Raman microscope, and a peak at 1330 cm⁻¹ of a diamond component having high crystallinity is displayed as red and a peak at 1450 cm⁻¹ of a diamond-like carbon (DLC) component is displayed as green, where a diamond component is divided into red (diamond), black red, red yellow, yellow, and green (DLC).

2. The Cu-diamond based solid phase sintered body according to claim 1,
wherein the used raw material powder is an industrial synthesized diamond powder having a particle size of 50 µm or more and 500 µm or less and not comprising a red yellow, yellow, or green portion of a diamond powder, provided that the diamond powder is analyzed with a laser Raman microscope, and a peak at 1330 cm⁻¹ of a diamond component having high crystallinity is displayed as red and a peak at 1450 cm⁻¹ of a diamond-like carbon (DLC) component is displayed as green, where a diamond component is divided into red (diamond), black red, red yellow, yellow, and green (DLC).

3. The Cu-diamond based solid phase sintered body according to claim 1,
wherein the proportion of the red diamond particle in the red and black red diamond particles is 20 vol% or more.

4. The Cu-diamond based solid phase sintered body according to claim 1, wherein the used raw material powder is an industrial synthesized diamond powder having a particle size of 50 µm or more and 500 µm or less, and comprising a red portion and a black red portion of a diamond powder, with a proportion of the red portion being 20 vol% or more and the balance being the black red portion, and not comprising a red yellow, yellow, or green portion, provided that the diamond powder is analyzed with a laser Raman microscope, and a peak at 1330 cm⁻¹ of a diamond component having high crystallinity is displayed as red and a peak at 1450 cm⁻¹ of a diamond-like carbon (DLC) component is displayed as green, when the diamond component is divided into red (diamond), black red, red yellow, yellow, and green (DLC).

5. A heat sink comprising the solid phase sintered body defined in claim 1, 2, 3 or 4.

6. An electronic device combined with the heat sink defined in claim 5, where they are thermally contacted with each other.

7. A method for producing the solid phase sintered body defined in claim 1, 2, 3 or 4, the method comprising the step of subjecting a mixture of a diamond powder, a Cu powder, and a Cr powder to solid phase sintering while pressurizing the mixture under a pressure of 20 MPa or more and 50 MPa or less in a mold in a vacuum or a reducing atmosphere at a temperature of 800°C or more and 1070°C or less.

## Patentansprüche

1. Cu-Diamant basierter gesinterter Festphasenkörper, umfassend:
30 Vol% oder mehr und 80 Vol% oder weniger eines Diamanten; und
2 Vol% oder mehr und 6 Vol% oder weniger Cr;
wobei der Rest des gesinterten Körpers Cu und unvermeidliche Verunreinigungen ist,
wobei das verwendete Rohmaterialpulver ein industriell synthetisiertes Diamantpulver ist, das keinen rot-gelben, gelben oder grünen Teil eines Diamantpulvers umfasst, vorausgesetzt, dass das Diamantpulver mit einem Laser-Raman-Mikroskop analysiert wird und ein Peak bei 1330 cm⁻¹ einer Diamantkomponente mit hoher Kristallinität als rot dargestellt wird und ein Peak bei 1450 cm⁻¹ einer diamantähnlichen Kohlenstoff- (DLC) Komponente als grün dargestellt wird, wobei eine Diamantkomponente in rot (Diamant), schwarz-rot, rot-gelb, gelb und grün (DLC) unterteilt ist.

2. Cu-Diamant basierter gesinterter Festphasenkörper nach Anspruch 1,
wobei das verwendete Rohmaterialpulver ein industriell synthetisiertes Diamantpulver mit einer Partikelgröße von 50 µm oder mehr und 500 µm oder weniger ist und keinen rot-gelben, gelben oder grünen Teil eines Diamantpulvers umfasst, vorausgesetzt, dass das Diamantpulver mit einem Laser-Raman-Mikroskop analysiert wird und ein Peak bei 1330 cm⁻¹ einer Diamantkomponente mit hoher Kristallinität als rot dargestellt wird und ein Peak bei 1450 cm⁻¹ einer diamantähnlichen Kohlenstoff- (DLC) Komponente als grün dargestellt wird, wobei eine Diamantkomponente in rot (Diamant), schwarz-rot, rot-gelb, gelb und grün (DLC) unterteilt ist.

3. Cu-Diamant basierter gesinterter Festphasenkörper nach Anspruch 1, wobei der Anteil des roten Diamantpartikels in den roten und schwarz-roten Diamantpartikeln 20 Vol% oder mehr beträgt.

4. Cu-Diamant basierter gesinterter Festphasenkörper nach Anspruch 1, wobei das verwendete Rohmaterialpulver ein industriell synthetisiertes Diamantpulver mit einer Partikelgröße von 50 µm oder mehr und 500 µm oder weniger ist und einen roten Teil und einen schwarz-roten Teil eines Diamantpulvers umfasst, wobei ein Anteil des roten Teils 20 Vol% oder mehr beträgt und der Rest der schwarz-rote Teil ist, und keinen rot-gelben, gelben oder grünen Teil umfasst, vorausgesetzt, dass das Diamantpulver mit einem Laser-Raman-Mikroskop analysiert wird und ein Peak bei 1330 cm⁻¹ einer Diamantkomponente mit hoher Kristallinität als rot dargestellt wird und ein Peak bei 1450 cm⁻¹ einer diamantähnlichen Kohlenstoff- (DLC) Komponente als grün dargestellt wird, wenn die Diamantkomponente in rot (Diamant), schwarz-rot, rot-gelb, gelb und grün (DLC) unterteilt ist.

5. Kühlkörper, umfassend den in Anspruch 1, 2, 3 oder 4 definierten gesinterten Festphasenkörper.

6. Elektronische Vorrichtung in Kombination mit dem in Anspruch 5 definierten Kühlkörper, wobei sie thermisch miteinander in Kontakt stehen.

7. Verfahren zur Herstellung des in Anspruch 1, 2, 3 oder 4 definierten gesinterten Festphasenkörpers, wobei das Verfahren den Schritt eines Aussetzens einer Mischung aus einem Diamantpulver, einem Cu-Pulver und einem Cr-Pulver eines Festphasensinterns umfasst, während die Mischung unter einem Druck von 20 MPa oder mehr und 50 MPa oder weniger in einer Form in einem Vakuum oder einer reduzierenden Atmosphäre bei einer Temperatur von 800 °C oder mehr und 1070 °C oder weniger unter Druck gesetzt wird.

## Revendications

1. Corps fritté en phase solide à base de Cu-diamant comprenant :
30 %vol ou plus et 80 %vol ou moins d'un diamant ; et
2 %vol ou plus et 6 %vol ou moins de Cr ;
le reste du corps fritté étant Cu et des impuretés inévitables,
dans lequel la matière première pulvérulente utilisée est une poudre de diamant synthétisé industriel ne comprenant pas une partie rouge jaune, jaune, ou verte d'une poudre de diamant, à condition que la poudre de diamant soit analysée avec un microscope laser Raman, et qu'un pic à 1330 cm⁻¹ d'un composant de diamant ayant une cristallinité élevée soit affiché en rouge et qu'un pic à 1450 cm⁻¹ d'un composant de carbone amorphe de type diamant (DLC) soit affiché en vert, où un composant de diamant est divisé en rouge (diamant), noir rouge, rouge jaune, jaune, et vert (DLC).

2. Corps fritté en phase solide à base de Cu-diamant selon la revendication 1,
dans lequel la matière première pulvérulente utilisée est une poudre de diamant synthétisé industriel ayant une taille particulaire de 50 µm ou plus et de 500 µm ou moins et ne comprenant pas une partie rouge jaune, jaune, ou verte d'une poudre de diamant, à condition que la poudre de diamant soit analysée avec un microscope laser Raman, et qu'un pic à 1330 cm⁻¹ d'un composant de diamant ayant une cristallinité élevée soit affiché en rouge et qu'un pic à 1450 cm⁻¹ d'un composant de carbone amorphe de type diamant (DLC) soit affiché en vert, où un composant de diamant est divisé en rouge (diamant), noir rouge, rouge jaune, jaune, et vert (DLC).

3. Corps fritté en phase solide à base de Cu-diamant selon la revendication 1, dans lequel la proportion de la particule de diamant rouge dans les particules de diamant rouge et noir rouge est de 20 %vol ou plus.

4. Corps fritté en phase solide à base de Cu-diamant selon la revendication 1, dans lequel la matière première pulvérulente utilisée est une poudre de diamant synthétisé industriel ayant une taille particulaire de 50 µm ou plus et de 500 µm ou moins, et comprenant une partie rouge et une partie noire rouge d'une poudre de diamant, avec une proportion de la partie rouge étant de 20 %vol ou plus et le reste étant la partie noire rouge, et ne comprenant pas une partie rouge jaune, jaune, ou verte, à condition que la poudre de diamant soit analysée avec un microscope laser Raman, et qu'un pic à 1330 cm⁻¹ d'un composant de diamant ayant une cristallinité élevée soit affiché en rouge et qu'un pic à 1450 cm⁻¹ d'un composant de carbone amorphe de type diamant (DLC) soit affiché en vert, lorsque le composant de diamant est divisé en rouge (diamant), noir rouge, rouge jaune, jaune, et vert (DLC).

5. Puits thermique comprenant le corps fritté en phase solide défini dans la revendication 1, 2, 3 ou 4.

6. Dispositif électronique combiné avec le puits thermique défini dans la revendication 5, où ils sont en contact thermique l'un avec l'autre.

7. Procédé pour produire le corps fritté en phase solide défini dans la revendication 1, 2, 3 ou 4, le procédé comprenant l'étape de soumettre un mélange d'une poudre de diamant, une poudre de Cu, et une poudre de Cr à un frittage en phase solide tout en pressurisant le mélange sous une pression de 20 MPa ou plus et de 50 MPa ou moins dans un moule sous vide ou sous une atmosphère réduite à une température de 800 °C ou plus et de 1070 °C ou moins.
